# EUROPÄISCHE PATENTSCHRIFT

(11) **EP 3 282 840 B1**
(45) Veröffentlichungstag und Bekanntmachung des Hinweises auf die Patenterteilung: **03.04.2019**
(21) Anmeldenummer: 16726761.6
(22) Anmeldetag: 12.04.2016
(51) Int. Cl.: A01M 29/28

(54) **VERFAHREN UND VORRICHTUNG ZUR ERZEUGUNG VON ELEKTROMAGNETISCHEN FELDERN, DIE DAS NERVENSYSTEM VON INSEKTEN BEEINFLUSSEN**
DEVICE AND PROCESS FOR GENERATING ELECTROMAGNETIC FIELDS WHICH INFLUENCE THE NERVOUS SYSTEM OF INSECTS
DISPOSITIF ET PROCÉDÉE POUR LA GÉNÉRATION DES CHAMPS ÉLECTROMAGNÉTIQUES QUI INFLUENCE LE SYSTÈME NERVEUX DES INSECTES

(30) Priorität: 13.04.2015 CH 5042015
(43) Veröffentlichungstag der Anmeldung: 21.02.2018
(73) Patentinhaber: Stoll, Rebecca, 8162 Steinmaur (CH); Stoll, Ruven, 8046 Zürich (CH)
(72) Erfinder: STOLL, Kurt, 8152 Glattbrugg (CH)
(74) Vertreter: Kaminski Harmann Patentanwälte AG (Schweiz)
(86) Internationale Anmeldenummer: PCT/CH2016/000065
(87) Internationale Veröffentlichungsnummer: WO 2016/165035

(56) Entgegenhaltungen:
- WO-A1-99/55151
- WO-A1-2012/094768
- CN-Y- 201 188 833
- CN-Y- 201 294 823

## Beschreibung

Die Malaria, Gelb- und Denguefieber sind nach wie vor die am weitesten verbreiteten durch blutsaugende Arthropoden (Vektoren) übertragene Infektionskrankheiten des Menschen, die jährlich mehrere Millionen Opfer - vor allem Kinder - fordert. Trotz aller Gegenmassnahmen breitet sich heute unter anderem die Malaria, bedingt durch Kriege und die damit verbundenen Flüchtlingsströme, Massentourismus sowie Klima- und ökologische Veränderungen, ständig weiter aus. Die Plasmodien, die Erreger der Malaria, sind gegen die meisten Chemotherapeutika resistent und auch die Überträgermücken (Anopheles-Mücken) haben gegen Insektizide eine Resistenz entwickelt. Grosse Anstrengungen werden unternommen, eine Vakzine gegen die Malaria zu entwickeln. Es wird aber voraussichtlich noch Jahre dauern, bis solche Vakzine auf dem Markt erhältlich sind. Ob diese Vakzine dann für die Bevölkerung in den Entwicklungsländern erschwinglich sind, ist fraglich. Zudem muss angenommen werden, dass auch gegen zukünftige Vakzine die Plasmodien eine Resistenz entwickeln. Ausser den chemisch behandelten Moskitonetzen, die jedoch nur einen sehr beschränkten Schutz für den Menschen gegen Mücken bieten, bestehen bis heute keine Methoden oder Strategien die Menschen gegen durch Vektoren übertragenen Krankheiten (z.B. Malaria, Gelbfieber, Denguefieber) zu schützen vermögen.

WO 99/55151 A1 beschreibt eine Vorrichtung, welche mit zwei elektrischen Oszillatoren Schwingungen erzeugt, welche je über ein Kontaktplättchen auf die Haut einer sich damit schützenden Person übertragen werden. Die beiden getrennten Schwingungen werden mit 1.2 KHz und 64.0 KHz und einer maximalen Leistungsdichte von 1mW/cm² auf die Hautoberfläche übertragen und an mit der Haut kontaktierende Stechmücken abgegeben.

WO 2012/094768 A1 beschreibt eine Vorrichtung, welche zwei Mikroprozessoren und zwei Sender umfasst. Eine gespeicherte Pulsform wird mit einer Trägerfrequenz von 565 KHz moduliert und über die beiden Sender und je daran angekoppelte Antennen in der Form von elektromagnetischen Wellen abgestrahlt.

Die erfinderische Aufgabe besteht darin, eine wirksamere Lösung zu finden.

Die Aufgabe wird durch eine Vorrichtung nach Anspruch 1 und ein Verfahren nach Anspruch 9 gelöst. Zur Abwehr von blutsaugenden Insekten erzeugt ein Zweikanal-Pulsmustersender 1 positive- und negative Pulsmuster, die um 180 Grad zueinander phasenverschoben sind 15,14, sowie die Modulationsfrequenz 4, die die Träger von den integrierten Sendern 28,29 modulieren und steuern, so dass diese über die integrierte zweiteilige Antenne, 34a 34b zwei um 180 Grad gegeneinander phasenverschobene, mit den Pulsmustern 15,14 gepulste, modulierte elektromagnetische Wellen 35a und 36a abstrahlt und zwei elektromagnetische Felder 35b, 36b erzeugt, die die Nervenzellen 50,53, die sich im in den Nervensystemen 48,53,63,64 von blutsaugenden Insekten befinden, so beeinflussen, dass die von den Neuronen erzeugten Signale und Reflexe Fehlverhalten auslösen, die die Insekten in einen inaktiven Zustand versetzen, so dass sie die menschliche Haut nicht penetrieren können und somit nicht zum Blutsaugen kommen.

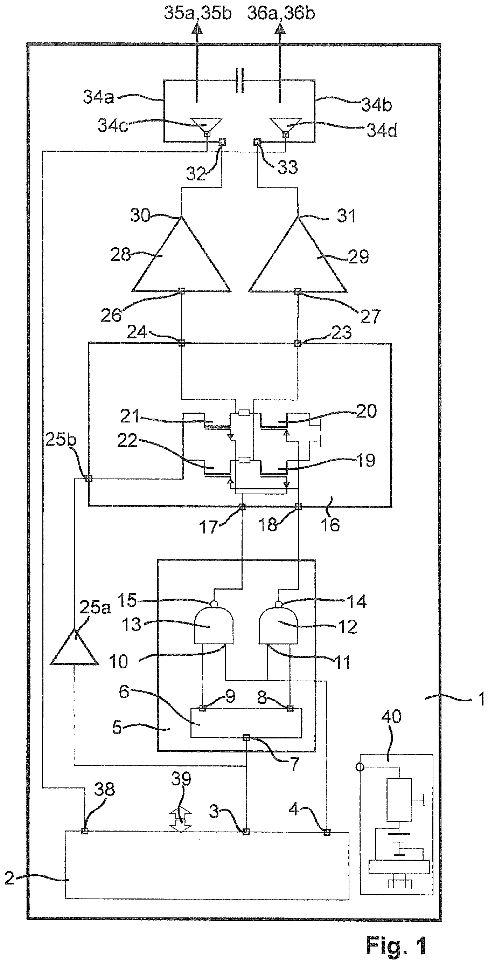

Das erfindungsgemässe Verfahren und die erfindungsgemässe Vorrichtung besteht aus einem autonomen Zweikanal-Pulsmustersender 1, Fig.1 in dem komplexe Baugruppen integriert sind, um positive, negative sowie phasenverschobene Pulsmustern zu erzeugen, die zwei Trägersignale in zwei Sendern modulieren und diese über eine Antenne an die äussere Umgebung als elektromagnetische Wellen und Feldern abstrahlt, die auf das Nervensystem von Insekten, insbesondere auf die im Oberschlundganglion und Unterschlundganglion befindenden Nervenzellen und den angedockten Axon-Terminale, die Signaltransfers unter den Nervenzellen aufbauen, so einwirken, dass sie nicht zum Stechen kommen.

Im Wesentlichen sind im Zweikanal-Pulsmustersender 1 der Mikroprozessor 2, Modulator 5, Pulsmusterkonverter 16, Sender 28, 29 und Antennen 34a und 34b mit Detektoren 34c und 34d sowie eine Stromversorgung 40 mit integrierter Batterie, die über einen Ladekontroller aufgeladen werden kann, als Baugruppen integriert. Zudem weist der Zweikanal-Pulsmustersender 1 zwei Antennendetektoren 34c, 34d auf, die

Informationen über Sendeleistung und die abgestrahlten elektromagnetischen Wellen 35a, 36a und -Feldern 35b, 36b zum Eingang 38 vom Mikroprozessor 2 transferieren, so dass über die Schnittstelle 39 diese Informationen ausgelesen werden können. Fig.1

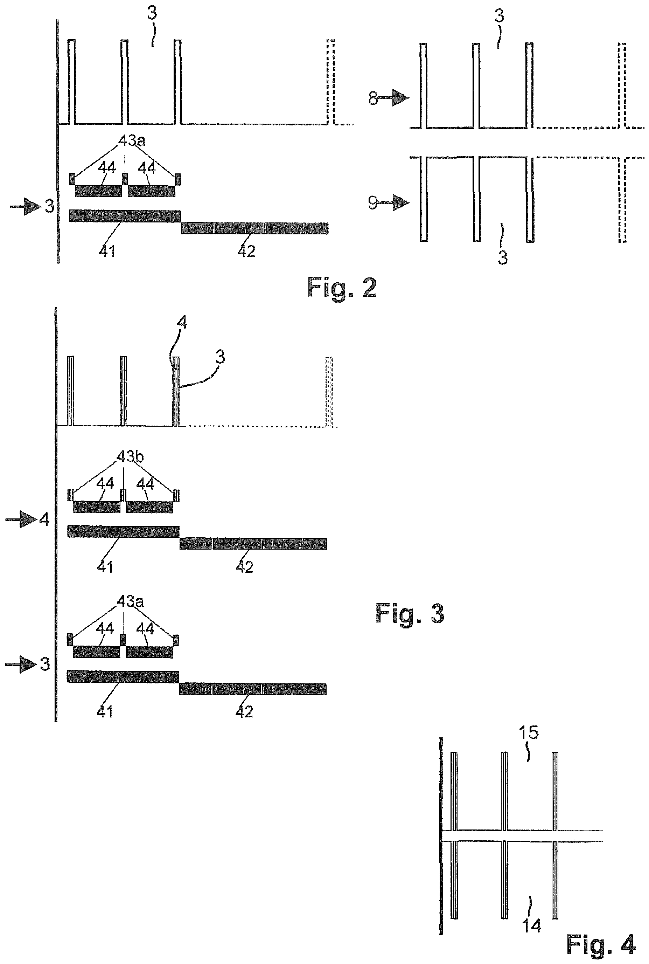

Der Mikroprozessor 2 erzeugt ein Pulsmuster 3, bestehend aus einem Puls 41 mit einer Pulsbreite von 204ms und einer Pulspause 42 von 5000ms. Innerhalb des Pulses 41 wird eine zweite Pulsquelle aufgebaut, bestehend aus drei Pulsen 43a von 12ms Pulsbreite und zwei Pulspause von 84ms 44. Fig.2 Das Modulationssignal am Ausgang 4 vom Mikroprozessor 2 wird erzeugt, indem das Pulsmuster 3 mit der Pulsfrequenz von 284 Hz 43b überlagert wird. Fig.3

Die Erfindung ist jedoch nicht nur auf die Modulationsfrequenz von 284 Hz (Pulsfrequenz) 4 beschränkt, insbesondere kann die Frequenz den unterschiedliche blutsaugenden Gliederfüsser angepasst und definiert werden.

Um positive und negative modulierte Pulsmuster zu erhalten, wird das vom Mikroprozessor 2 erzeugte Pulsmuster 3 Fig.2 dem nachgeschalteten Modulator 5 und dem Eingang 7 der Kippstufe 6 zugeleitet, die am Ausgang 8, ein positives Pulsmuster 3 erzeugt Fig.2, das zum dem Eingang 10b vom nachgeschalteten NAND Gatter 13 geleitet wird. Zeitgleich wird am Ausgang 9 (der Kippstufe 6), ein negatives Pulsmuster 3 erzeugt Fig.2, das zum Eingang 11b vom nachgeschalteten NAND Gate 12 geleitet wird. Das vom Mikroprozessor 2 erzeugte Modulationssignal 4 Fig.3 wird zum Eingang 10a vom nachgeschalteten NAND Gatter 13 und zum Eingang 11a vom nachgeschalteten NAND Gatter 12 geleitet. Somit liegt am Ausgang 15 vom NAND Gatter 13 das positive modulierte Pulsmuster an und am Ausgang 14 vom NAND Gatter 12 das negative modulierte Pulsmuster an. Fig.4

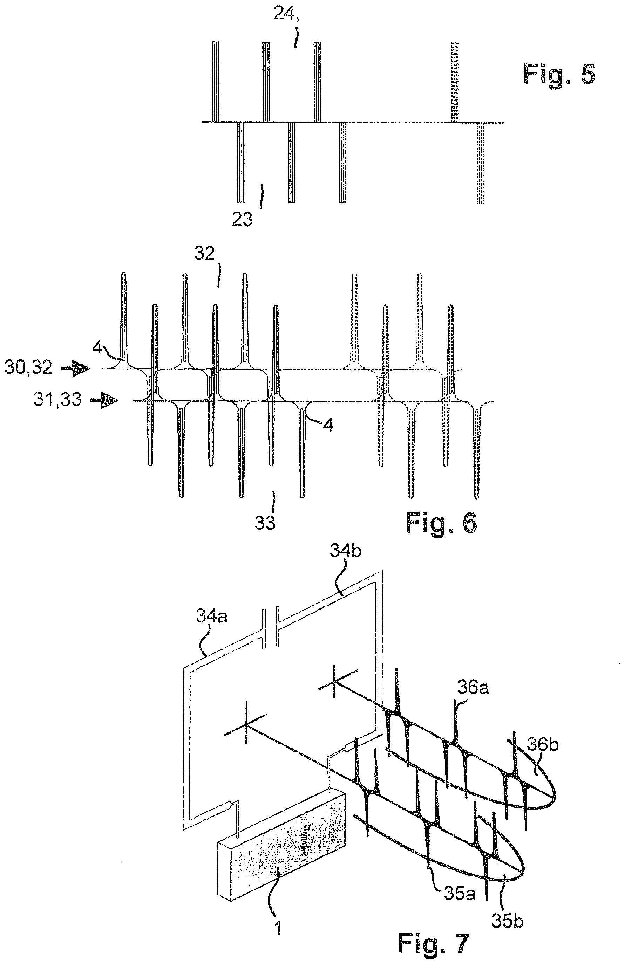

Der Pulsmusterkonverter 16 besteht aus vier FETs, die so zueinander geschaltet sind, um zwei modulierte Pulsmuster 3, die gegeneinander um 180 Grad phasenverschoben sind, zu erhalten. Um diese Vorgaben zu erfüllen, wird das Pulsmuster 3, das über den Treiber 25a und dem Eingang 25b den beiden Drains der FETs 21 und FET 22 zugeführt. Zeitgleich wird das modulierte positive Pulsmuster 15 über den Eingang 17 an die Gates der FETs 19 und 21 geleitet und das modulierte negative Pulsmuster 14 über den Eingang 18 an die Gates der FET 20 und 22 geleitet. Aus dieser Aktion wird die Richtung des Signalflusses vom positive Pulsmuster 24, das am Source vom FET 21 anliegt, durch eine Pulsfolge über FET 20 zur Masse festgelegt und die Richtung des Signalflusses vom negativen Pulsmuster 23, das am Drain vom FET 19 anliegt, durch eine Pulsfolge über FET 22 zum Pulsmuster 3, das am Eingang 25b anliegt, so dass zwei Pulsmuster 24, 23, die gegeneinander um 180° phasenverschoben sind, erzeugt werden. Fig.5

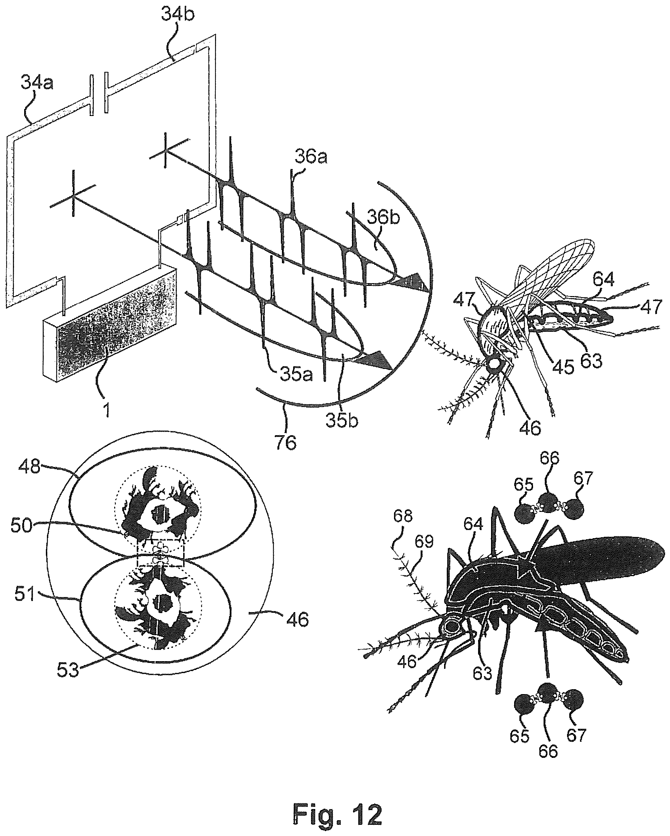

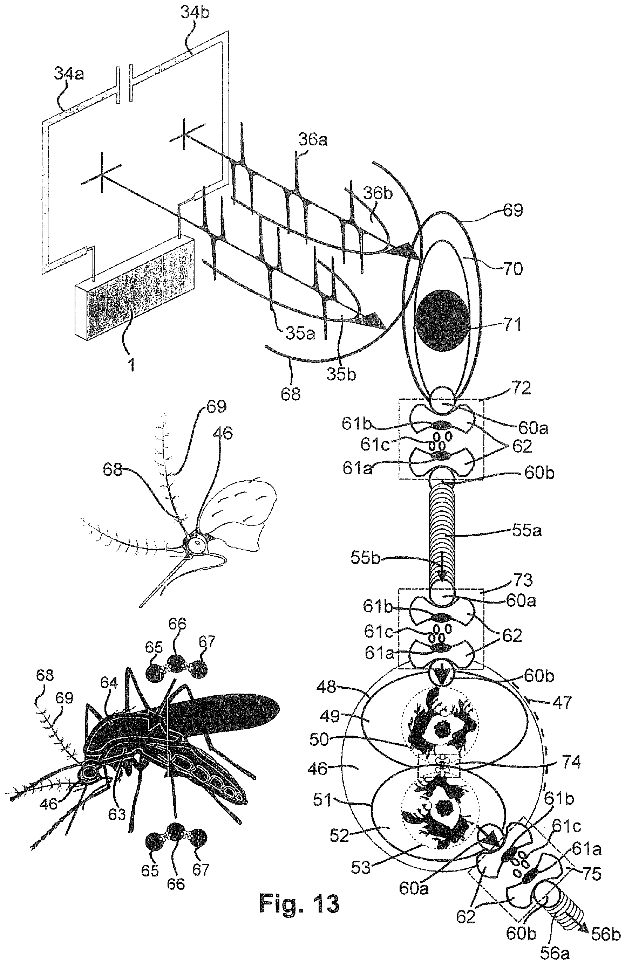

Aus dieser Aktion wird das modulierte Pulsmuster 24, (das gegenüber dem Pulsmuster 23 um 180 Grad phasenverschobene ist), zum Eingang 26 vom Sender 28 geleitet, um dessen Oszillator, der die Trägerfrequenz von 160 KHz erzeugt, zu modulieren und zu steuern. Zugleich wird das modulierte Pulsmuster 23, (das gegenüber dem Pulsmuster 24 um 180 Grad phasenverschobene ist), zum Eingang 27 vom Sender 29 geleitet, um dessen Oszillator, der die Trägerfrequenz von 160 KHz erzeugt, zu modulieren und zu steuern. Durch diese Aktionen entstehen zwei mit den Pulsmustern 24 und 23 Fig.5 gepulste und modulierte Träger, die eine Trägerfrequenz von 160KHz aufweisen, die zueinander um 180 Grad phasenverschoben sind Fig. 6. Über die jeweiligen Senderausgänge 30 und 31, die eine Sendeleistung von je 2mW aufweisen, werden die beiden Träger zu den Anschlüssen 32 und 33 der integrierten zweiteiligen Magnetantenne 34a und 34b (magnetische Loops) geleitet, die zwei zueinander um 180 Grad phasenverschobene , mit den Pulsmustern 24, 23 gepulste, modulierte elektromagnetische Wellen 35a und 36a abstrahlt und zwei elektromagnetische Felder 35b und 36b erzeugt. Fig.7 Im Strahlungsbereich 76 Fig. 12,13 (Ausbreitung der elektromagnetischen Wellen und - Felder in den Raum) von zirka 30 Metern zur integrierten zweiteiligen Magnetantenne 34a und 34b besteht eine Leistungsdichte,(eingespeiste Leistung von 2mW in die Antenne) die genügt, dass die abgestrahlten elektromagnetischen Wellen 35a, 36a, sowie die erzeugten elektromagnetischen Felder 35b,36b auf ein blutsaugendes Insekt so einwirken, so dass diese das Nervensystem beeinflussen und stören können.(In den Grafiken Fig. 7,12, 13 sind die Ausbreitungsrichtungen der elektromagnetischen Welle 35a, 36a und elektromagnetischen Felder 35b, 36b nur in einer Richtung und einer Ebene dargestellt.)

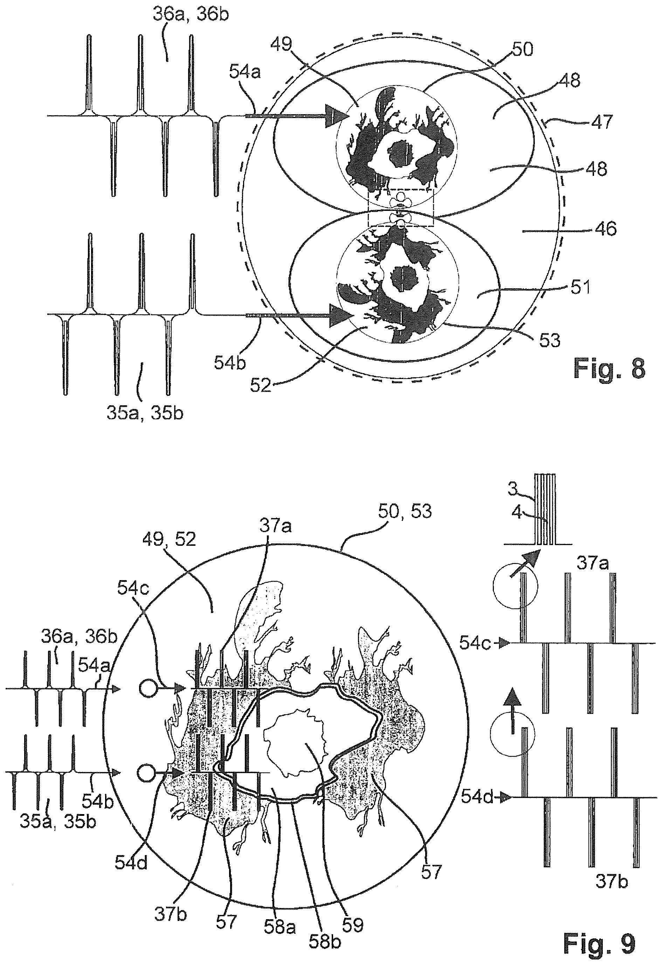

Die Erfindung ist jedoch nicht nur auf die angegebenen Parameter der Leistungsdichte, abgestrahlte Energie, sowie Modulationsfrequenz (Schaltfrequenz), Trägerfrequenz und Sendeleistung beschränkt, insbesondere können die angegeben Pulsmustern sowie Träger- und Modulationsfrequenzwerte den verschiedenen Insektenarten angepasst und definiert werden. Laborversuche mit Flugkäfige und Feldtests mit Aedes aegypti, dem Gelbfieberüberträger und mit Anopheles stephensi, einem Malariaüberträger haben gezeigt, dass verschiedene Trägerfrequenzen, (beispielsweise 433MHz, 910MHz, 1800 MHz, 2,44GHz, 10GHz, 24,4 GHz) sowie Schaltfrequenzen (beispielsweise 43Hz, 470Hz, 1800Hz, 2457Hz, 22KHz, 56KHz) gute Ergebnisse erbrachten, um das zentrale Nervensystem 63 und das periphere Nervensystem 64 Fig.12 der Insekten, insbesondere die im Oberschlundganglion 48 und Unterschlundganglion 53 befindenden Neuronen 50,53 sowie deren Axon-Terminale 62, (die sich in den biologischen Schnittstellen 72,73,74 und 75 befinden), so zu beeinflussen, dass sie nicht zum Stechen kommen. Fig. Fig.8, 9, 12, 13 Gemäss einer Ausgestaltung des erfindungsgemässen Verfahrens werden die weiteren Prozesse in Fig.8 näher definiert.

Befinden sich blutsaugende Insekten 45 im Strahlungsbereich 76 Fig. 12,13 (Ausbreitung der elektromagnetischen Wellen und - Felder in den Raum) von zirka 30 Metern zur integrierten zweiteiligen Magnetantenne 34a und 34b, werden sie zu Strahlungsempfänger, indem die Bestrahlung des Insekt durch die Einwirkung der elektromagnetischen Wellen 35a und 36a, sowie der elektromagnetische Felder 35b, 36b (die von der integrierten Antenne 34a und 34b, im Zweikanal-Pulsmustersenders 1 abgestrahlt werden) erfolgt, so dass das Chitin-Exoskelett 47 die Funktion von einem Demodulator übernimmt, indem die Chitinfasern einen Schwingkreis bilden, der in Eigenresonanz versetzt wird, so dass nur noch die niederfrequenten Modulationsfrequenz 4 sowie die um 180 Grad gegeneinander phasenverschobenen elektromagnetischen Pulsmustern 37a und 37b zum Oberschlundganglion 48 und Unterschlundganglion 51, die sich im Insektenkopf 46 befinden, gelangen. Damit findet eine Einstrahlung der niederfrequenten elektromagnetischen Wellen 35a und 36a, und elektromagnetischen Feldern 35b, 36b auf die sensorischen Neuronen 50, (die sich im Oberschlundganglion 48 befinden), und von den motorischen Neuronen 53 (die sich im Unterschlundganglion 51 befinden) statt, so dass die biologischen Prozesse (Erregungstransfer, elektrische Signal- und Reflex Erzeugung) erheblich gestört werden.

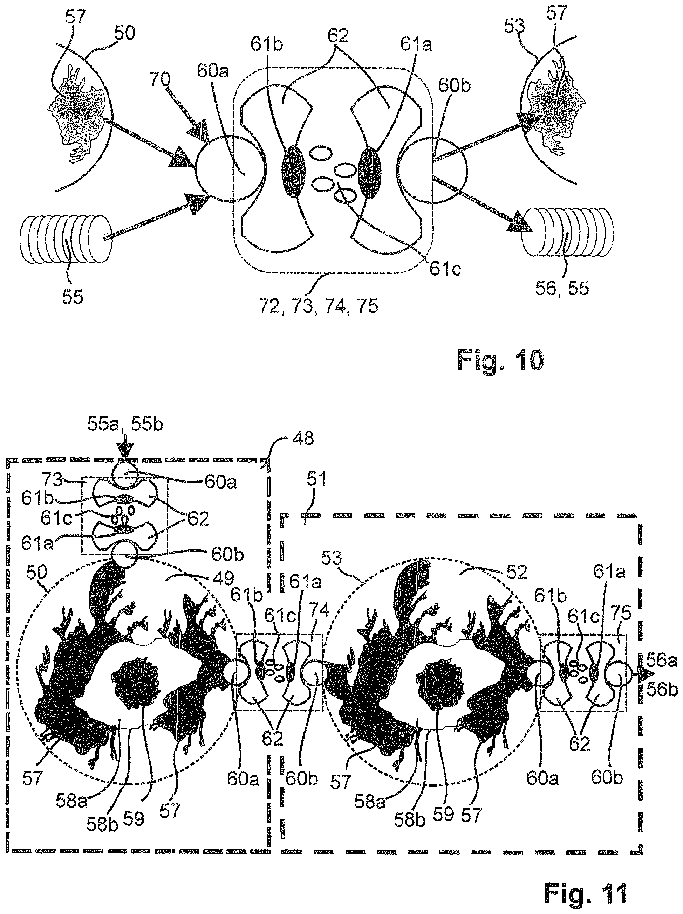

Gemäss einer weiteren Ausgestaltung des erfindungsgemässen Verfahrens werden die weiteren Prozesse in Fig.9, Fig.11 näher beschrieben und definiert. Die Einstrahlung der Modulationsfrequenz 4 und Pulsmuster 37a und 37b in das sensorische Neuron 50 (das sich im Oberschlundganglion 48 befindet) beeinflussen den Aufbau (Signalaufbau SA) der elektrischen Potentiale (elektrische Signale) an der Zellmembrane 49, die aus der elektrischen Depolarisierung vom negativen zum positiven (bzw. weniger negativer Wert) Ladungszustand an der Innenseite der Zellmembran 49 stammen, so dass durch die um 180 Grad phasenverschobenen Pulsmuster 37a und 37b, durch den Wechsel von der positiven zur negativen Phase, sowie der Modulationsfrequenz 4 die die Zellmembran 49 in den Zustand von ihre Eigenschwingung bringt, diese erheblich gestört wird. Die Repolarisation (Wiederherstellung des Ruhemembranpotentials nach vorangegangener Depolarisation) wird so beeinflusst, dass sie noch während der Depolarisierung aktiv wird, oder teilweise ausfällt. Die schadhaften Informationen (elektrische Signale) gelangen zum Dendrit 57, der die dezimierten Signale über die angedockten Axone 60a 60b von der Schnittstelle 74 zum Dendrit 57 vom motorischen Neuron 53 (das sich im Unterschlundganglion 51 befindet) transferiert. Die Einstrahlung der Pulsmuster 37a und 37b in das motorische Neuron 53 beeinflussen den Aufbau der Reflexe an der Zellmembrane 52 in gleicher Weise, wie im Signalaufbau SA beschriebenen biologischen Abläufe, die die gleichen biologischen Prozesse aufweisen, wie die im sensorischen Neuron 49, ausser dass statt elektrische Signale, Reflexe und Reflexinformationen an der Oberfläche der Zellmembran 52 aufgebaut werden.

Über das Axon 60b der biologischen Schnittstelle 75 erfolgt der Reflexsignaltransfer über den motorischen Nervenstrang 56 zum zentralen Nervensystem 63. Über zugeordnete biologischen Schnittstellen werden die fehlerhaften Reflexe zu den motorischen Neuronen geleitet, die die Muskeln, Drüsen und Organbewegungen steuern, so dass Insekten, die sich im Strahlungsbereich 76 der elektromagnetischen Wellen 35a und 36a, sowie der elektromagnetische Felder 37a, 37b befinden, inaktive Verhaltensweisen aufweisen, die teilweise zu Schlafzustände führen, so dass blutsaugende Insekten nicht zum Stechen kommen.

Gemäss einer weiteren Ausgestaltung des erfindungsgemässen Verfahrens werden die weiteren Prozesse in Fig.10 näher definiert. Der biologische Prozess von der Signal- oder von der Reflexübertragung innerhalb der biologischen Schnittstellen 72, 73, 74 und 75 erfolgt, indem die ankommende Signale, die von den zugeordneten Dendriten 57 im sensorischen Neuron 50 oder vom sensorischen Nerv 55 stammen, an das angedockte Axon 60a vom Axonterminal 62 geleitet werden, die den Neurotransmitter 61b aktivieren, so dass eine elektrochemische Impulsübertragung 61c (Synapse) zum Neurorezeptor 61a erfolgt, der die empfangenen Informationen zum Axon 60b weiterleitet, so dass diese zu den zugeordneten Dendriten 57 im motorischen Neuron 53 oder zum motorischen Nervenstrang 56 Nervenstrang) gelangen. Durch die Einstrahlung der Modulationsfrequenz 4 und den Pulsmuster 37a und 37b wird bei der elektrochemische Impulsübertragung 61c (Synapse) zwischen Neurotransmitter 61b und Neurorezeptor 61a der Ionen- und Molekültransfer so beeinflusst, dass das Membranpotential am Neurorezeptor 61a zu stark abgesetzt wird, so dass eine Verzögerung der Impulsübertragung stattfindet, die zu Fehlfunktionen der nachfolgenden Prozessabläufen führt.

Gemäss einer weiteren Ausführung der Erfindung Fig.13, lösen die vom Pulsmustersender 1abgestrahlten, mit dem Pulsmuster 3 modulierte und gepulste elektromagnetischen Wellen 35a und 36a, und elektromagnetische Felder 37a, 37b, am Reizempfänger 71 der Sensille 69, die sich an der Antenne 68 befindet, Reizsignale aus, die eine Fluchtreaktion der Mücke einleiten, Die gleiche Aktion entsteht, von den Pulsmustern, die aus dem Umfeld stammen, beispielsweise von einer atmosphärischen Entladung, die gleiche Pulsmustern aufweisen.

Durch die Einwirkung der elektromagnetischen Feldern wird der Reizempfängers 71, der sich in der Sinneszelle 70 befindet, in Resonanz gebracht, so dass ein Reizsignal erzeugt wird, das bei der Sinneszelle 70 eine Aktion auslöst, die elektrische Impulse an der Zelloberfläche von der Sinneszelle 70 aufbaut (elektrisches Potenzial), die aus der elektrischen Depolarisierung vom negativen zum positiven Ladungszustand an der Innenseite der Zellmembran stammen. Aus dieser Aktion gelangen die erzeugten elektrischen Signale zur biologischen Schnittstelle 72. Der elektrochemische Signaltransfer erfolgt über den sensorischen Nerv 55 zum Axon 60a von der biologischen Schnittstelle 73 über das Axon 60b zum Dendrit 57a vom sensorischen Neuron 50, das sich im Oberschlundganglion 48, (Insektenhirn) befindet. Die Weiterleitung der Signale zum Zellkern 59 erfolgt, idem der Dendrit 57 und der Zellkörper 58 in einen Erregungszustand gesetzt werden, die den Zellkern 59 anregen, so dass elektrische Potentiale in Form von elektrischen Pulsen an der Zelloberfläche aufgebaut werden, die aus der elektrischen Depolarisierung vom negativen zum positiven Ladungszustand an der Innenseite der Zellmembran stammen, so dass der Neurit 57 über den Zellkörper 58 durch die elektrischen Pulse, ein Aktionspotential aufbaut, das eine Weiterleitung des elektrischen Signals an das angedockten Axon 60a von der biologischen Schnittstelle 74, die das Oberschlundganglion 48 mit dem Unterschlund-ganglion 51 vernetzt, einleitet. Die Einleitung der motorischen Prozesse, die die Bewegungsabläufe für eine Fluchtreaktion der Mücke aktiviert, erfolgt, indem die elektrischen Impulse über das Axon 60b von der der biologischen Schnittstelle 74, zum Dendrit 57a vom motorischen Neuron 50, das sich im Unterschlundganglion 51 befindet, weiter geleitet werden Die Weiterleitung der Signale zum Zellkern 59 erfolgt, indem der Dendrit 57a und der Zellkörper 58 in einen Erregungszustand gesetzt werden, die den Zellkern 59 anregen, so dass elektrische Potentiale in Form von elektrischen Reflexe an der Zelloberfläche aufgebaut werden, die aus der elektrischen Depolarisierung vom negativen zum positiven Ladungszustand an der Innenseite der Zellmembran stammen, so dass das Neurit 57a über den Zellkörper 58 durch die erzeugten elektrischen Reflexe und Reflexinformationen, ein Aktionspotential aufbaut, das eine Weiterleitung der Reflexe an das angedockte Axon 60a von der biologischen Schnittstelle 75 erfolgt. Über das Axon 60b der biologischen Schnittstel

le 75 erfolgt der Reflextransfer über den motorischen Nervenstrang 56 zum zentralen Nervensystem 63. Über zugeordnete biologischen Schnittstellen werden die Reflexinformationen zu den motorischen Neuronen geleitet, die die Motorik (Muskeln und Drüsen) der Insekten - Flügel steuert, um eine Fluchtreaktion einzuleiten, so dass sich das Insekt aus dem Strahlungsbereich der elektromagnetischen Wellen 35a und 36a, sowie elektromagnetische Felder 37a, 37b, die vom Zweikanal-Pulsmustersender 1, abgestrahlt werden, entfernt.

Die Mücke ist nicht in der Lage zu unterscheiden ob ihr eine natürliche oder eine künstlich erzeugte Gefahr droht, sie wird in jedem Fall die Flucht ergreifen. Somit kann sie auch keine Resistenz entwickeln (oder bedingte) gegenüber dem erfindungsgemässen Verfahren und Vorrichtung zur Erzeugung von elektromagnetischen Wellen 35a, 36a und - Feldern 35b, 36b, die gleiche Parameter und Strukturen aufweisen, wie die, die aus einer natürlichen Quelle stammen.

Es wird darauf hingewiesen, dass natürlich jede der oben beschriebenen Ausführungsvarianten auch die sensorischen Neuronen 65, motorischen Neuronen 66 und Interneuronen 67 die sich im Nervensystem von Insekten befinden, durch die Einstrahlung der vom Zweikanal-Pulsmustersender 1erzeugten elektromagnetischen Wellen 35a, 36a und -Feldern 35b, 36b, so beeinflusst und gestört werden, so dass ein inaktives Fehlverhalten ausgelöst wird.

Insekten können kein angestammtes Verhalten speichern, weil ein komplexer Nervenknoten im Oberschlundganglion und ein dritter Nervenstrang zum Unterschlundganglion fehlen. Durch elektrische Reflexe (Reflexsignale, Reflexinformationen) werden die Muskel-, Drüsen und Organbewegungen gesteuert, so dass Ansätze zu Verhaltensweisen und bedingte Lernvorgänge durch eine konzentrierte Abfolge der Reflexe bestehen. Durch die Einstrahlung der vom Zweikanal-Pulsmustersender 1erzeugten elektromagnetischen Wellen 35a, 36a und -Feldern 35b, 36b werden diese Reflexsignale und Reflexinformationen so beeinflusst und gestört, so dass ein Fehlverhalten ausgelöst wird, das blutsaugenden Insekten in einen inaktiven Zustand versetzt.

In blutsaugenden Insekten befinden sich einige hunderttausende Nervenzellen, folglich werden diese in den Fig. 8,9,10,11,12,13 als einzelne Nervenzellen 50, 53,65,66 ,67 dargestellt.

## Patentansprüche

1. Vorrichtung zur Abwehr von blutsaugenden Insekten mit einem Zweikanal-Pulsmustersender (1), der einen Mikroprozessor (2) und zwei Sender (28, 29) umfasst und über integrierte Antennen (34a,34b) elektromagnetische Wellen (35a,36a) abstrahlbar macht, wobei die erzeugten elektromagnetischen Felder (35b und 36b) Neuronen (50,53) im Oberschlund- und Unterschlund-Ganglion (48,51), sowie Neuronen im zentralen und peripheren Nervensystem (63,64) von blutsaugenden Insekten (45) beeinflussen, um sie in einen inaktiven Zustand zu versetzten, in welchem sie die menschliche Haut nicht penetrieren und somit nicht zum Blutsaugen kommen, **dadurch gekennzeichnet, dass** der Zweikanal-Pulsmustersender (1) auch einen Modulator (5) und einen Pulsmusterkonverter (16) umfasst, wobei ein vom Mikroprozessor (2) erzeugtes Pulsmuster (3) vom Modulator (5) an einem ersten Ausgang (15) als positiv und an einem zweiten Ausgang (14) als negativ moduliertes Pulsmuster (24, 23) für Eingänge (17, 18) des Pulsmusterkonverters (16) bereitstellbar ist und der Pulsmusterkonverter (16) das positiv modulierte und das negativ modulierte Pulsmuster (24, 23) phasenverschoben den Sendern (28, 29) zuführbar macht.

2. Vorrichtung nach Anspruch 1 **dadurch gekennzeichnet, dass** der Zweikanal-Pulsmustersender (1) als kompakter, autonomer Baustein ausgeführt ist.

3. Vorrichtung nach Anspruch 1 oder 2 **dadurch gekennzeichnet, dass** zu einem Driver (25a) eine Spule geschaltet wird, die synchron mit dem Pulsmuster (3) ansteuerbar ist, so dass eine Spannungsspitze erzeugt wird, die über den Eingang (25b) vom Pulsmusterkonverter (16) einem FET (21, 22) zuführbar ist, so dass die zwei Pulsmuster (24, 23), zusätzlich mit einem Nadelimpuls überlagerbar sind.

4. Vorrichtung nach einem der vorhergehenden Ansprüche, **dadurch gekennzeichnet, dass** der Modulator (5) mit zwei NAND Gattern erweitert ist, um die an den Ausgängen (14, 15) anliegenden Pulsmustern mit einem Hochfrequenzsignal zu überlagern, um an den Ausgängen (24,23) vom Pulsmusterkonverter (16) zwei Trägersignale zu erzeugen, die an die Antennenanschlüsse (32,33) weiter geleitet werden.

5. Vorrichtung nach einem der vorhergehenden Ansprüche **dadurch gekennzeichnet, dass** der Zweikanal-Pulsmustersender (1) in ein mobiles System, eine Armbanduhr, ein Armband oder einen Anhänger integriert ist.

6. Vorrichtung nach einem der Ansprüche 1 bis 5 **dadurch gekennzeichnet, dass** der Zweikanal-Pulsmustersender (1) in einem netzbetriebenen- oder einem batteriebetriebenen System oder in einem System, das eine von Solarzellen oder Brennstoffzellen gespeiste Stromversorgung aufweist, integriert ist.

7. Vorrichtung nach einem der vorhergehenden Ansprüche, **dadurch gekennzeichnet, dass** der Zweikanal-Pulsmustersender (1) als kompakter, autonomer Baustein in ein Wundpflaster integriert ist.

8. Vorrichtung nach einem der vorhergehenden Ansprüche, **dadurch gekennzeichnet, dass** der Zweikanal-Pulsmustersender (1) zwei zusätzliche Endstufen umfasst, die in Serie zu den Sendern (28,29) zuschaltbar sind, um den Strahlungsbereich (76) zu vergrössern.

9. Verfahren zur Abwehr von blutsaugenden Insekten mit einem Zweikanal-Pulsmustersender (1), der einen Mikroprozessor (2) und zwei Sender (28, 29) umfasst und über integrierte Antennen (34a,34b) elektromagnetische Wellen (35a,36a) abstrahlt, wobei die erzeugten elektromagnetischen Felder (35b und 36b) Neuronen (50,53) im Oberschlund- und Unterschlund-Ganglion (48,51), sowie Neuronen im zentralen- und peripheren Nervensystem (63,64) von blutsaugenden Insekten (45) beeinflussen, um sie in einen inaktiven Zustand zu versetzten, in welchem sie die menschliche Haut nicht penetrieren und somit nicht zum Blutsaugen kommen, **dadurch gekennzeichnet, dass** der Zweikanal-Pulsmustersender (1) auch einen Modulator (5) und einen Pulsmusterkonverter (16) umfasst, ein vom Mikroprozessor (2) erzeugtes Pulsmuster (3) vom Modulator (5) an einem ersten Ausgang (15) als positiv und an einem zweiten Ausgang (14) als negativ moduliertes Pulsmuster für Eingänge (17, 18) des Pulsmusterkonverter (16) bereitgestellt wird und der Pulsmusterkonverter (16) das positiv modulierte und das negativ modulierte Pulsmuster phasenverschoben den Sendern (28, 29) zuführt.

## Claims

1. A device for repelling bloodsucking insects with a two-channel pulse pattern transmitter (1) which comprises a microprocessor (2) and two transmitters (28, 29) and, via integrated antennas (34a, 34b), renders electromagnetic waves (35a, 36a) emittable, wherein the electromagnetic fields (35b and 36b) generated influence neurons (50, 53) in the supraesophageal and suboesophageal ganglions (48, 51), and neurons in the central and peripheral nervous system (63, 64) of bloodsucking insects (45) in order to put them into an inactive state in which they do not penetrate the human skin and thus do not suck the blood, **characterised in that** the two-channel pulse pattern transmitter (1) also comprises a modulator (5) and a pulse pattern converter (16), wherein a pulse pattern (3) generated by the microprocessor (2) can be provided for inputs (17, 18) of the pulse pattern converter (16) by the modulator (5) at a first output (15) as a positively modulated and at a second output (14) as a negatively modulated pulse pattern (24, 23), and the pulse pattern converter (16) makes it possible to deliver the positively modulated and the negatively modulated pulse patterns (24, 23) to the transmitters (28, 29) in a phase-shifted manner.

2. The device according to Claim 1, **characterised in that** the two-channel pulse pattern transmitter (1) takes the form of a compact, autonomous module.

3. The device according to Claim 1 or 2, **characterised in that** a coil is connected to a driver (25a) which coil can be controlled synchronously with the pulse pattern (3) such that a voltage peak is generated which can be delivered to an FET (21, 22) via the input (25b) of the pulse pattern converter (16), such that the two pulse patterns (24, 23) can additionally be overlaid with a spike pulse.

4. The device according to any one of the preceding claims, **characterised in that** the modulator (5) is expanded with two NAND gates in order to overlay the pulse patterns which are applied to the outputs (14, 15) with a high frequency signal, in order to generate at the outputs (24, 23) of the pulse pattern converter (16) two carrier signals which are forwarded to the antenna terminals (32, 33).

5. The device according to any one of the preceding claims, **characterised in that** the two-channel pulse pattern transmitter (1) is integrated in a mobile system, a wristwatch, a wristband or a pendant.

6. The device according to any one of Claims 1 to 5, **characterised in that** the two-channel pulse pattern transmitter (1) is integrated in a mains-operated or a battery-operated system or into a system which has a power supply which is supplied by solar cells or fuel cells.

7. The device according to any one of the preceding claims, **characterised in that** the two-channel pulse pattern transmitter (1) is integrated in an adhesive plaster as a compact, autonomous module.

8. The device according to any one of the preceding claims, **characterised in that** the two-channel pulse pattern transmitter (1) comprises two additional power amplifiers, which can be connected in series to the transmitters (28, 29), in order to expand the radiation range (76).

9. A method for repelling bloodsucking insects with a two-channel pulse pattern transmitter (1) which comprises a microprocessor (2) and two transmitters (28, 29) and which, via integrated antennas (34a, 34b), emits electromagnetic waves (35a, 36a), wherein the generated electromagnetic fields (35b and 36b) influence neurons (50, 53) in the supraesophageal and suboesophageal ganglions (48, 51) and neurons in the central and peripheral nervous system (63, 64) of bloodsucking insects (45), in order to put them into an inactive state in which they do not penetrate the human skin and thus do not suck the blood, **characterised in that** the two-channel pulse pattern transmitter (1) also comprises a modulator (5) and a pulse pattern converter (16), a pulse pattern (3) generated by the microprocessor (2) is provided for inputs (17, 18) of the pulse pattern converter (16) by the modulator (5) at a first output (15) as a positively modulated and at a second output (14) as a negatively modulated pulse pattern, and the pulse pattern converter (16) delivers the positively modulated and the negatively modulated pulse patterns to the transmitters (28, 29) in a phase-shifted manner.

## Revendications

1. Dispositif pour repousser des insectes hématophages avec un émetteur de motifs d'impulsions à deux canaux (1), comprenant un microprocesseur (2) et deux émetteurs (28, 29) et pouvant émettre des ondes électromagnétiques (35a, 36a) à l'aide d'antennes intégrées (34a, 34b), les champs électromagnétiques (35b et 36b) générés agissant sur des neurones (50, 53) des ganglions sus-oesophagien et sous-oesophagien (48, 51) et sur des neurones du système nerveux central et périphérique (63, 64) d'insectes hématophages (45) afin de les faire passer dans un état inactif dans lequel ils ne pénètrent pas à travers la peau humaine et n'aspirent donc pas de sang, **caractérisé en ce que** l'émetteur de motifs d'impulsions à deux canaux (1) comprend aussi un modulateur (5) et un convertisseur de motifs d'impulsions (16), de sorte qu'un motif d'impulsions (3) généré par le microprocesseur (2) peut être délivré par le modulateur (5) sur une première sortie (15) comme un motif d'impulsions à modulation positive et sur une deuxième sortie (14) comme un motif d'impulsions à modulation négative (24, 23) pour des entrées (17, 18) du convertisseur de motifs d'impulsions (16) et le convertisseur de motifs d'impulsions (16) permet la transmission des motifs d'impulsions à modulation positive et négative (24, 23) aux émetteurs (28, 29) avec un décalage de phase.

2. Dispositif selon la revendication 1, **caractérisé en ce que** l'émetteur de motifs d'impulsions à deux canaux (1) est réalisé comme un composant autonome compact.

3. Dispositif selon la revendication 1 ou 2, **caractérisé en ce qu'**un excitateur (25a) est connecté à une bobine qui peut être activée de façon synchronisée avec le motif d'impulsions (3), de façon à créer un pic de tension qui peut être transmis via l'entrée (25b) du convertisseur de motifs d'impulsions (16) à un transistor à effet de champ (21, 22) de sorte qu'une impulsion en pointe peut en outre être superposée aux deux motifs d'impulsions (24, 23).

4. Dispositif selon l'une des revendications précédentes, **caractérisé en ce que** le modulateur (5) est augmenté par deux grilles N-ET afin de superposer un signal à haute fréquence aux motifs d'impulsions présents aux sorties (14, 15) pour créer sur les sorties (24, 23) du convertisseur de motifs d'impulsions (16) deux signaux porteurs qui sont transmis aux connexions d'antenne (32, 33).

5. Dispositif selon l'une des revendications précédentes, **caractérisé en ce que** l'émetteur de motifs d'impulsions à deux canaux (1) est intégré dans un système mobile, une montre-bracelet, un bracelet ou un pendentif.

6. Dispositif selon l'une des revendications 1 à 5, **caractérisé en ce que** l'émetteur de motifs d'impulsions à deux canaux (1) est intégré dans une système fonctionnant sur secteur ou sur piles ou dans un système alimenté en électricité par des cellules photovoltaïques ou des piles à combustible.

7. Dispositif selon l'une des revendications précédentes, **caractérisé en ce que** l'émetteur de motifs d'impulsions à deux canaux (1) est intégré comme un composant autonome compact dans un pansement.

8. Dispositif selon l'une des revendications précédentes, **caractérisé en ce que** l'émetteur de motifs d'impulsions à deux canaux (1) présente deux étages d'extrémité supplémentaires qui peuvent être montés en série avec les émetteurs (28, 29) pour augmenter la portée de rayonnement (76).

9. Procédé pour repousser des insectes hématophages avec un émetteur de motifs d'impulsions à deux canaux (1) qui comprend un microprocesseur (2) et deux émetteurs (28, 29) et qui émet des ondes électromagnétiques (35a, 36a) à l'aide d'antennes intégrées (34a, 34b), les champs électromagnétiques (35b et 36b) générés agissant sur des neurones (50, 53) des ganglions sus-oesophagien et sous-oesophagien (48, 51) et sur des neurones du système nerveux central et périphérique (63, 64) d'insectes hématophages (45) afin de les faire passer dans un état inactif dans lequel ils ne pénètrent pas à travers la peau humaine et n'aspirent donc pas de sang, **caractérisé en ce que** l'émetteur de motifs d'impulsions à deux canaux (1) comprend également un modulateur (5) et un convertisseur de motifs d'impulsions (16), un motif d'impulsions (3) généré par le microprocesseur (2) peut être délivré par le modulateur (5) sur une première sortie (15) comme un motif d'impulsions à modulation positive et sur une deuxième sortie (14) comme un motif d'impulsions à modulation négative pour des entrées (17, 18) du convertisseur de motifs d'impulsions (16) et le convertisseur de motifs d'impulsions (16) transmet les motifs d'impulsion à modulation positive et négative aux émetteurs (28, 29) avec un décalage de phase.
